(19) **Europäisches Patentamt**

**European Patent Office**

**Office européen des brevets**

(11) **EP 1 566 847 A1**

(12) **EUROPEAN PATENT APPLICATION**

(43) Date of publication:
24.08.2005 Bulletin 2005/34

(51) Int Cl.⁷: **H01L 33/00**

(21) Application number: 05100676.5

(22) Date of filing: 01.02.2005

| | |
|---|---|
| (84) Designated Contracting States:<br>**AT BE BG CH CY CZ DE DK EE ES FI FR GB GR HU IE IS IT LI LT LU MC NL PL PT RO SE SI SK TR**<br>Designated Extension States:<br>**AL BA HR LV MK YU**<br><br>(30) Priority: **18.02.2004 US 782248**<br><br>(71) Applicant: **Lumileds Lighting U.S., LLC**<br>**California 95131 (US)**<br><br>(72) Inventors:<br> • **Harbers, Gerard c/o Lumileds Lighting, U.S., LLC**<br> **San Jose, CA 95131 (US)**<br> • **Keuper, Matthijs, H. Lumileds Lighting, U.S., LLC**<br> **San Jose, CA 95131 (US)** | • **Steigerwald, Daniel, A.**<br> **Lumileds Lighting U.S.,LLC**<br> **San Jose, CA 95131 (US)**<br><br>(74) Representative: **van der Veer, Johannis Leendert Philips**<br> **Intellectual Property & Standards**<br> **P.O. Box 220**<br> **5600 AE Eindhoven (NL)**<br><br><u>Remarks:</u><br> A request for correction of the claims has been filed pursuant to Rule 88 EPC. A decision on the request will be taken during the proceedings before the Examining Division (Guidelines for Examination in the EPO, A-V, 3.). |

(54) **Illumination system with LEDs**

(57) The luminance of a system that includes a light emitting diode (LED), such as a projection system, may be increased by using an LED chip that has a light emitting surface that emits light directly into any medium with a refractive index of less than or equal to approximately 1.25. For example, the LED chip may emit light directly into the ambient environment, such as air or gas, instead of into an encapsulant. The low refractive index decreases the étendue of the LED, which increases luminance. Moreover, without an encapsulant, a collimating optical element, such as a lens, can be positioned close to the light emitting surface of the LED chip, which advantageously permits the capture of light emitted at large angles. A secondary collimating optical element may be used to assist in focusing the light on a target, such as a micro-display.

Fig. 13

EP 1 566 847 A1

**Description**

FIELD OF THE INVENTION

The present invention relates generally to increasing the luminance in a high radiance system that uses light emitting diodes, such as in a projection system.

BACKGROUND

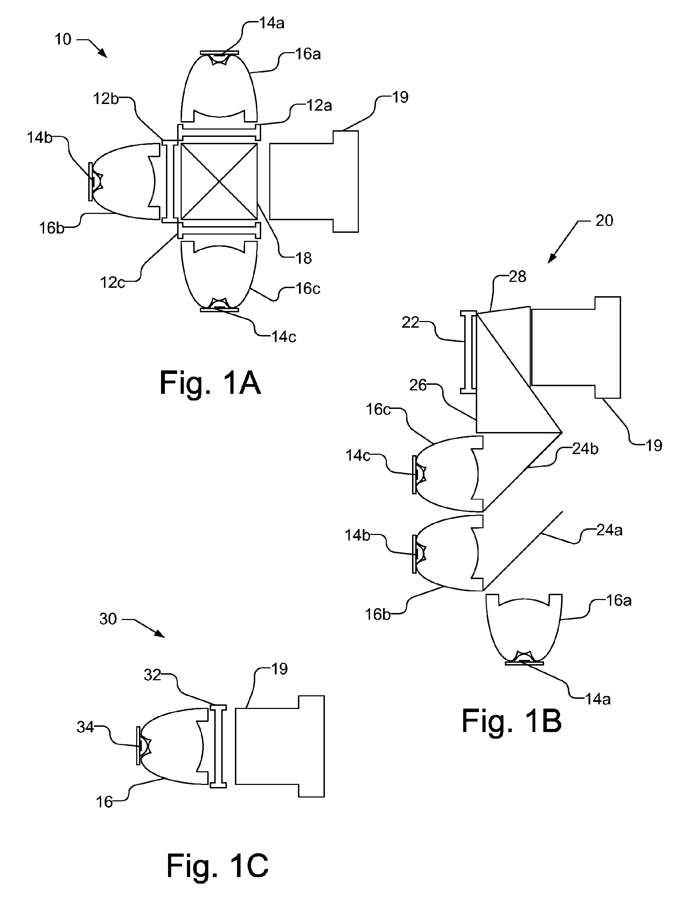

Figs. 1A, 1B, and 1C schematically illustrate various known illumination architectures for projection systems that use light emitting diodes (LEDs). Fig. 1A shows an architecture 10 that includes a number of transmissive micro-displays 12a, 12b, 12c (sometimes collectively referred to as display 12) that are illuminated with respective LEDs 14a, 14b, 14c (sometimes collectively referred to as LEDs 14). The LEDs 14 illuminate the displays 12 through one or more collimating lenses 16a, 16b, and 16c (sometimes collectively referred to as lenses 16). The lenses 16 collect the light from the LEDs 14 and focus the light on the display 12. The LEDs 14 illuminate the displays 12 with different colors, preferably red, green, and blue. The micro-displays may be, by way of example, high temperature poly-silicon (HTPS) displays such as those produced by Seiko-Epson and Sony. The images of the three displays 12 are combined with a prism 18, which may be, e.g., an X-cube. A projection lens 19 is used to project the image from the prism 18 onto a screen, which is not shown.

Fig. 1B shows another illumination architecture 20 that includes similar components as shown in Fig. 1A (like designated elements being the same) but uses a single reflective micro-display 22 in a configuration for a micro-electromechanical system (MEMS), as manufactured by, e.g., Texas Instruments as a digital mirror display. The micro-display 22 cycles through different colored images, such as red, green, and blue, as it is being illuminated by different colored light from LEDs 14a, 14b, 14c. The different color states of the micro-display 22 are made by switching the LEDs 14 on and off and combining the colors using dichroic mirrors 24a and 24b. The image from micro-display 22 is received by lens 19 through prism 26 and 28, which are part of a Total Internal Reflection prism.

Fig. 1C shows another illumination architecture 30 that includes a single transmissive micro-display 32 that is a color liquid crystal display (LCD), such as the type produced by Sony. The micro-display 32 is illuminated with a white LED 34 through a collimating lens 16.

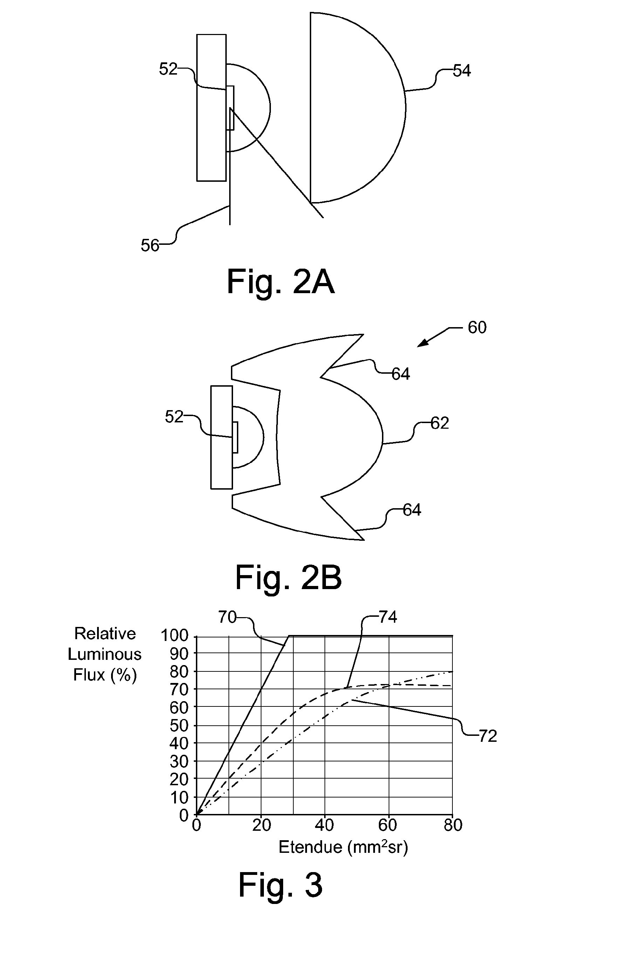

As illustrated in Figs. 1A, 1B, and 1C, the light from the LEDs needs to be collected and focused onto the micro-display, e.g., by a collimating lens 16. The use of a lens between the LED and micro-display is necessary as the micro-display and projection lens only transmit light that is received within a particular area and at a particular angle. Different types of lens systems can be used to collect and focus the light from the LEDs onto the micro-display. Fig. 2A illustrates the use of a plano-convex lens 54 in conjunction with an LED 52. Of course, other types of lenses may be used as well, such as a bi-convex lens or an aspheric type lens or even a combination of several lenses. The disadvantage of using a plano-convex lens 54, or other similar lenses, is that light that is emitted at a large angle from LED 52, as illustrated by lines 56, is not collected and thus is not focused on the micro-display.

Fig. 2B illustrates a configuration in which a collimator lens system 60, which is a combination of aspheric lenses 62, is used to collect light emitted by the LED 52 in the forward direction, and total internal reflection optics 64 to collect light emitted at larger angles, e. g., toward the sides of the LED 52.

Fig. 3 is a graph illustrating the typical performance of a collimator lens such as that shown in Fig. 2B. The graph illustrates the collection efficiency as a function of étendue for the source (line 70), the collimator (line 72), and the micro-display (line 74). The collection efficiency of the collimator is defined by the flux out of the collimator divided by the flux out of the light source, and the collection efficiency of the micro-display is defined by the flux onto the micro-display divided by the flux out of the light source.

The étendue for a general optical beam is defined as follows:

$$E = \int\int n^2 \, dA \, d\Omega \qquad \text{eq. 1}$$

where n is the refractive index of the medium into which the source is emitting, dA is the area, and $d\Omega$ is the centroid of the solid angle. If an LED is considered a surface emitter, the étendue of an LED may be written as:

$$E = n^2 \pi A \, sin^2\theta \qquad \text{eq. 2}$$

wherein $\theta$ is the collection half angle.

The étendue is important in a projection system as the throughput of the total optical system, i.e., the maximum luminous flux of the projection system ($\phi_p$), is limited by the étendue of the micro-display, as follows:

$$\phi_p = \eta_p E_{MD} L \qquad \text{eq. 3}$$

where $\eta_p$ is the projector efficiency, L is the luminance of the light beam illuminating the micro-display and $E_{MD}$ is the étendue of the micro-display projection lens combination. The luminance (L) of the illuminating light beam is determined by the product of the flux of the LEDs ($\phi_{LED}$) and the efficiency of the illuminator ($\eta_{ill}$) di-

vided by the étendue of the light source ($E_{LED}$) as follows:

$$L = \frac{\eta_{ill}\ \phi_{led}}{E_{LED}}. \qquad \text{eq. 4}$$

Typical values for the étendue of a micro-display are in the range of 10 to 30 mm$^2$sr. As can be seen from the graph in Fig. 3, the actual collection efficiency for the collimator (line 72) and the micro-display (line 74) is only 20% to 50% for this range of an étendue. However, the theoretical achievable efficiency for an LED light source (line 70) as shown in Fig. 3, is 35% to 100% for the same étendue.

SUMMARY

In accordance with an embodiment of the present invention, the luminance of a system with a light emitting diode (LED) can be increased by using an LED chip with a light emitting surface that emits light directly into any medium with a refractive index of less than or equal to approximately 1.25. For example, the LED chip may emit light directly into the ambient environment, such as air or gas, instead of into an encapsulant, which typically have refractive indices much greater than 1.25, e.g., between 1.45 and 1.55. The present invention decreases the étendue of the LED, which increases luminance. Moreover, without an encapsulant, a collimating optical element, such as a lens, can be positioned close to the light emitting surface of the LED chip, which advantageously permits the capture of light emitted at large angles. A secondary collimating optical element may be used to assist in focusing the light on a target, such as a micro-display.

In some embodiments, an apparatus includes a light emitting diode that includes a chip that has a light emitting surface that emits light into a medium with a refractive index of less than or equal to approximately 1.25. The apparatus further includes a collimating optical element disposed to receive the light emitted from the light emitting surface of the chip, wherein the medium is disposed between the entrance surface of the collimating optical element and the light emitting surface of the chip.

In some embodiments, an apparatus includes a light emitting diode that includes a chip that has a light emitting surface that is not covered by an encapsulant such that the light emitting surface emits light directly into the ambient environment. The apparatus further includes a collimating optical element disposed to receive the light emitted from the light emitting surface of the chip through the ambient environment.

In some embodiments, an apparatus includes a light emitting diode that includes a chip that has a light emitting surface that emits light into a medium with a refractive index of less than or equal to approximately 1.25 and includes a collimating optical element and a micro-display. The collimating optical element is disposed to receive the light emitted from the light emitting surface of the chip, and the micro-display is disposed to receive the light emitted from the light emitting surface of the chip after the light passes through the collimating optical element.

In some embodiments, a method includes providing a light emitting diode with a light emitting surface that emits light directly into a medium having a refractive index of less than or equal to approximately 1.25 and providing an optical element. The method includes mounting the optical element with respect to the light emitting diode so that light emitted from the light emitting surface passes through the medium prior to being received by the optical element.

BRIEF DESCRIPTION OF THE DRAWINGS

Figs. 1A, 1B, and 1C schematically illustrate various known illumination architectures for projection systems.
Fig. 2A illustrates the use of a plano-convex lens in conjunction with an LED.
Fig. 2B illustrates the use of a collimator lens system, which is a combination of aspheric lenses and total internal reflection optics.
Fig. 3 is a graph illustrating the typical performance of a collimator lens such as that shown in Fig. 2B.
Fig. 4 shows a cross-sectional view of a conventional high power LED.
Fig. 5A illustrates an LED that may be used in a high luminance system, in accordance with an embodiment of the present invention.
Fig. 5B illustrates a cross sectional view of the LED illustrated in Fig. 5A.
Fig. 6 illustrates a collimator lens used with an LED, in accordance with an embodiment of the present invention.
Fig. 7 shows a closer view of the LED chip and portion of the collimator lens from Fig. 6.
Fig. 8 shows a side view of a device with a lens mounted in close proximity to an LED chip 152, in accordance with one embodiment of the present invention.
Fig. 9 shows a side view of a device that includes a secondary lens to further collimate the light emitted from the LED chip.
Fig. 10 shows a side view of a device that includes an array of LED devices and a secondary lens array.
Fig. 11 shows a device in which an LED chip decentered with respect to the proximity lens.
Fig. 12 shows a device that includes an array of LED devices, some of which are decentered with respect to an associated proximity lens and a secondary lens array.

Fig. 13 shows a side view of a device that includes a plurality of LED dice mounted on a single submount under the same collimator lens.

DETAILED DESCRIPTION

In accordance with an embodiment of the present invention, a light emitting diode (LED) that is used in high radiance systems, such as in a projection system, automobile headlights, optical fibers, or the like, includes a light emitting surface that emits light into a low refractive index medium, e.g., $n \leq 1.25$. The use of a medium with a low refractive index, which may be, e. g., air or gas, reduces the étendue and, thus, increases the luminance of the LED.

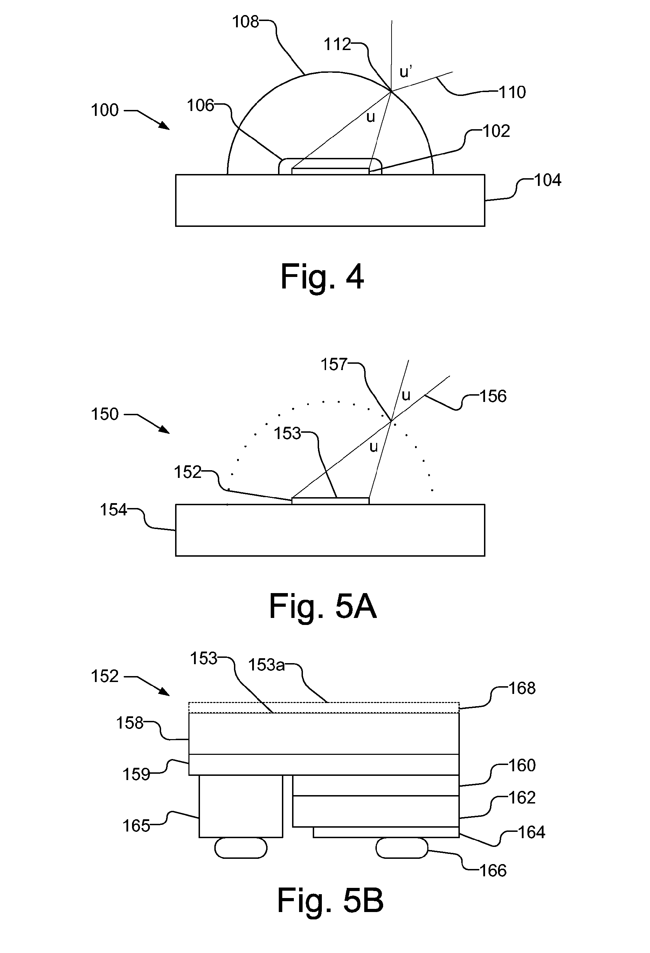

Fig. 4 shows a cross-sectional view of a conventional high power LED 100. The LED 100 includes a chip 102 (sometimes referred to as a die), which produces the light emitted by the LED, and which is mounted on a submount 104 or a heatsink. Conventionally, the chip is protected by an encapsulant 106, which is typically manufactured from epoxy or silicon gel, and a plastic molded lens 108 that covers the encapsulant 106. In some LEDs, the encapsulant 106 is used to form a lens, and thus, the encapsulant 106 and lens 108 will be described herein as an encapsulant for ease of reference. The encapsulant generally increases extraction efficiency and provides protection for sensitive elements of the chip 102, such as wire bonds.

As discussed above, in reference to equations 1 and 2, the refractive index (n) of the medium into which the light source is emitting affects the étendue. Thus, because the chip 102 emits light directly into encapsulant 106, the refractive index of the encapsulant affects the étendue of the device. The encapsulant typically used with conventional LEDs has a refractive index (n) in the range of 1.45 to 1.55. As can be seen in equation 4, the luminance (L) of the devices is inversely related to the étendue (E). Thus, a disadvantage of the use of a conventional LED 100 with an encapsulant with a high refractive index is that the luminance of the device is decreased.

Fig. 5A illustrates an LED 150 that may be used in a high luminance system, in accordance with an embodiment of the present invention. LED 150 includes a chip 152 with a light emitting surface 153 that emits light directly into the ambient environment, e.g., the air or a gas, or a surrounding medium with a refractive index of approximately 1.25 or less. Because the LED chip 152 emits light into a medium with a refractive index of approximately 1.25 or less, and conventional encapsulants have indices of refraction of 1.45 to 1.55, the LED 150 is sometime referred to herein as an unencapsulated LED. The LED chip 152 is illustrated as being mounted on a base element 154, which is, e.g., a submount, a heatsink or any other element to which an LED chip may be mounted. The base element 154 is sometimes referred to herein as submount 154, but it should be understood, this element may be a heatsink or any other appropriate element.

For the sake of reference, the location of an encapsulant/lens if one were used with LED 150 is illustrated by the dotted line. Without an encapsulant, the chip 152 emits light directly into air, which has a refractive index of approximately 1. Because LED 150 emits light into a medium that has a lower refractive index than a conventionally used encapsulant 106, LED 150 will have a lower étendue, and thus, a higher throughput in a projection system. By way of example, if the extraction efficiency into air is the same as that for an encapsulant, the throughput of a device using LED 150 can be improved by the square of the refractive index ($n^2$), i.e., about 2.25 for a refractive index of 1.5. In practice, the gain will be lower, as the extraction efficiency into air is lower than that into an encapsulant.

Fig. 5B illustrates a cross sectional view of the LED chip 152, in accordance with one embodiment. Chip 152 has a flip-chip design, which advantageously eliminates wire bonds. Chip 152 has a layer of first conductivity type 159 formed on a substrate 158, where the light emitting surface 153 is the surface of the substrate 158. If the device shown in Fig. 5B is a III-nitride light emitting diode, the first conductivity type layer 159 may be an n-type III-nitride layer and substrate 158 may be sapphire, SiC, GaN, or any other suitable substrate. A light emitting region 160, also sometimes referred to as the active region, is formed on first conductivity type layer 159, then a layer of second conductivity type 162 is formed on the active region 160. A first contact 165 is connected to layer 159 and a second contact 164 is connected to layer 162. At least one of contacts 164 and 165 may be reflective which increases light output. Interconnects 166 connect the light emitting diode to submount 154 shown in Fig. 5A. Interconnects 36 may be, for example, solder bumps or gold bumps.

As illustrated in Fig. 5B, the chip 152 does not include an encapsulant, and thus, light is emitted directly from the light emitting surface 153 into the ambient environment, such as air or a surrounding gas. In one embodiment, chip 152 may include one or more additional layers 168. By way of example, layer 168 may be a wavelength converting material, such as a fluorescent material, e.g., phosphor, that converts the wavelength of the light produced by chip 152. It should be understood that when the LED chip 152 includes one or more additional layers 168, the light emitting surface of the LED chip 152 is surface 153a, as illustrated in Fig. 5B. Layer 168, or overlaying layers, may also be, e.g., a filter, such as a dichroic filter, or a polarizer, such as a wire-grid polarizer, a diffractive optical structure, or micro refractive optical structure.

The effect on the refractive index is illustrated in Figs. 4 and 5A with the light rays 110 and 156 respectively. As is well known, the angle of incidence and refraction is defined by Snell's law, which is:

$$n \sin u = \sin u' . \qquad \text{eq. 5}$$

where n and u are the refractive index and angle inside the medium in which the chip is embedded, while n' and u' are the refractive index and angle of the medium in which the LED is used, such as air. As illustrated in Fig. 4, at the interface 112 of the lens 108, incident light with an angle u is emitted with a larger angle u'. However, as illustrated in Fig. 5A, without the lens 108 or encapsulant 106, light having an incident angle u at point 157, which is at the same point as interface 112 in Fig. 4, the refraction does not occur.

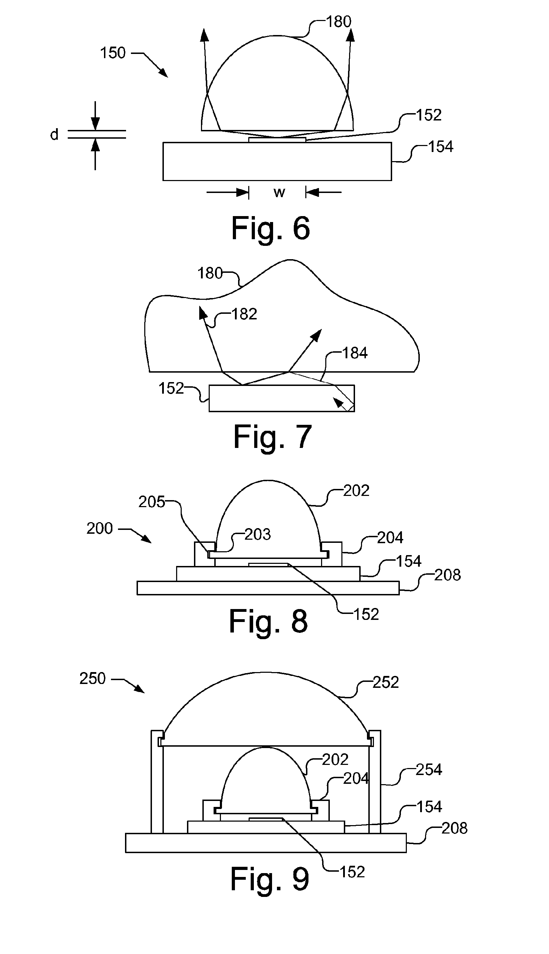

Fig. 6 illustrates an embodiment of the present invention in which an optical element, such as a collimator lens 180 is used with unencapsulated LED 150, shown as LED chip 152 mounted on submount 154. Advantageously, without an encapsulant, the lens 180 may be placed close to the chip 152. Thus, light that is emitted from the chip 152 at large angles can be captured using a relatively small lens and thus, the collection efficiency is improved relative to conventional systems. By way of example, the lens 180 may be placed a distance of 50μm or greater from the chip 152. In general, the distance (d) between the lens 180 and the chip 152 should be approximately 50% of the width (w) of the chip 152 or less. Of course, any desired distance between the lens 180 and the chip 152 may be used, if desired. While the lens 180 is illustrated as a plano-convex aspheric lens in Fig. 6, other lens types may be used as well. Moreover, if desired, other optical elements may be used. By way of example, the lens 180 may be replaced with a diffractive optical element.

Fig. 7 shows a side view of the chip 152 and a portion of the lens 180. As illustrated in Fig. 7, because the lens 180 is close to the chip 152, a light ray 182 that is emitted from the chip 152 is refracted into a much smaller angle inside the lens 180. Moreover, light that is reflected by the lens 180, as illustrated with light ray 184, maybe reflected back onto the chip 152, where the light may be reflected off the top of the chip 152 or internally within the chip 152 and back to the lens 180. Thus, a portion of light reflected from the lens 180 may be recycled. The ability to recycle light that is reflected back into the chip is improved through the use of highly reflective contacts, e.g., which may be manufactured from silver or aluminum or an alloy thereof. Further, the incorporation of an optical scattering element within the LED chip will enhance the recycling process.

Increasing the light generating capability of LEDs, e.g., through recycling light and the use of reflective contacts, is discussed in U.S. Patent Nos. 6,486,499 and 6,091,085, which are incorporated herein by reference.

Fig. 8 shows a side view of a device 200 that illustrates mounting a lens 202 in close proximity to an unencapsulated chip 152, in accordance with one embodiment of the present invention. The device 200 includes a holding element that holds the lens 202. By way of example, the holding element may be a ring 204 with a notch 205, where the lens 202 includes an annular tab or a plurality of separate tabs that are held by the notch 205. It should be understood that the lens 202 may be a single lens or one or more bonded lens, e.g., a plate bonded to a plano-convex lens. The ring 204 surrounds and holds the lens 202, e.g., the tab 203 is inserted into the notch 205 of the ring. In one embodiment, the ring 204 is manufactured from metal, such as copper, and is heated so that it expands. The lens 202, which may be a glass or plastic lens, is then inserted into the ring 204 and the ring 204 is allowed to cool, thereby shrinking the ring 204 to hold the lens 202. The ring 204 may be mounted on the same submount 154 as the chip 152, e.g., by reflow-soldering, which advantageously provides a precise alignment between the chip 152 and the lens 202. The submount 154 is shown mounted on a submount carrier 208. Other types of holding elements may be used if desired, such as a plurality of posts that hold the lens 202.

Fig. 9 shows a side view of a device 250 that is similar to device 200, like designated elements being the same, except device 250 includes a secondary lens 252 that is used to further collimate the light emitted from the chip 152, in accordance with another embodiment of the present invention. As shown in Fig. 9, the secondary lens 252 is mounted on a ring 254 that maybe similar to ring 204. In one embodiment, ring 254 is mounted to the submount carrier 208, but in other embodiments, ring 254 may be mounted elsewhere, e.g., to the submount 154 itself. While the secondary lens 252 is illustrated as a plano-convex lens, other lens types may be used as well. Moreover, if desired, other optical elements may be used, such as diffractive optical elements.

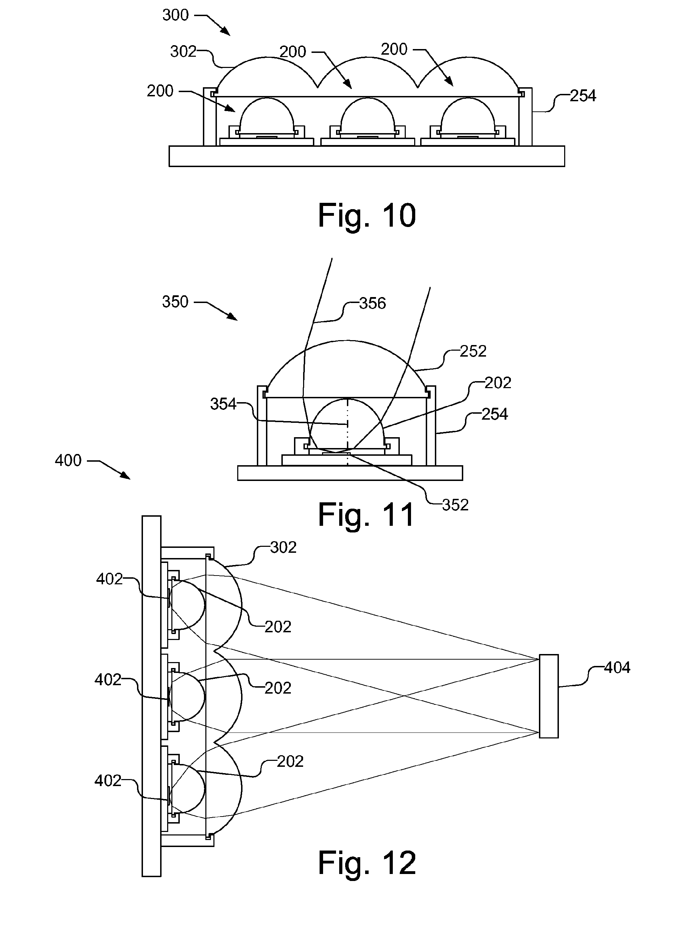

Fig. 10 shows a side view of a device 300 that is similar to device 250, but includes an array of unencapsulated LED devices 200 and uses a secondary lens array 302 to further collimate the light emitted from the devices 200, in accordance with another embodiment of the present invention. The lens array 302 may be manufactured from plastic, e.g., injection molded as a single part.

In one embodiment, the LED chip may be decentered with respect to the proximity lens so as to deflect the resulting beam at a desired angle. Fig. 11 illustrates an embodiment of a device 350, that is similar to device 250, but in which an LED chip 352 is laterally displaced with respect to the center 354 of the proximity lens 202. As illustrated by the light rays 356, the resulting light beam is deflected at an angle with respect to normal.

The use of a decentered LED chip may be used advantageously with an array configuration. Fig. 12 illustrates a side view an embodiment of a device 400 that includes a number of LED chips 402, some of which are decentered with respect to an associated proximity lens 202 and also includes a secondary lens array 302.

As shown, by controlling the amount of decentering of the LED chips 402, the light from the LED chips 402 can be focused onto a target 404 without any additional optics. By way of example, the center LED chip 402 is not decentered so that its emitted light is focused onto the target 404. One particular useful application of device 400 is when the LED chips 402 produce different colors, e.g., red, green and blue that can be combined to produce a single white beam. Such an embodiment maybe particularly useful where the target 404 is a grating or a hologram. Alternatively, the target 404 may be a micro-display, such as an angular separated LCD, with a micro lens array or hologram/grating applied on the micro-display itself. It should be understood that Fig. 12 depicts a linear array of LED elements, but a two dimensional array may be used, which will enable a more compact light source. By way of example, a triangle configuration of red, green and blue chips or a square configuration of red, green, blue, and green chips may be used.

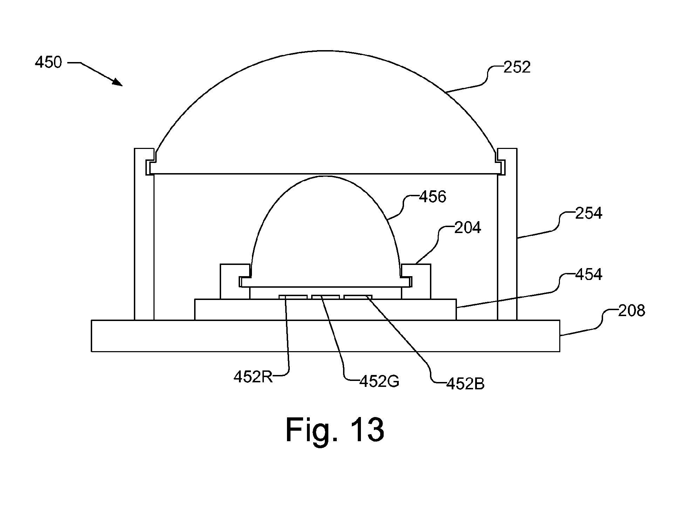

Fig. 13 illustrates a device 450 that is similar to device 250 shown in Fig. 9, like designated elements being the same. Device 450, however, includes a plurality of LED dice 452R, 452G, and 452B, all of which are mounted on the same submount 454. The LED dice 452R, 452G, and 452B, by way of example, may produce red, green and blue light. The device 450 also includes a single lens 456 that covers the LED dice 452R, 452G, and 452B. The lens 456 may be designed to compensate for any decentering of the dice 452R, 452G, and 452B, which is well understood in the art. It should be understood that while Fig. 9 illustrates the dice 452R, 452G, and 452B in a linear array, a two dimensional array may be used, e.g., in a triangular configuration. Further, if desired additional dice may be used, e.g., in a square configuration.

Although the present invention is illustrated in connection with specific embodiments for instructional purposes, the present invention is not limited thereto. Various adaptations and modifications may be made without departing from the scope of the invention. Therefore, the spirit and scope of the appended claims should not be limited to the foregoing description.

**Claims**

1. An apparatus comprising:

   - a light emitting diode comprising a chip having a light emitting surface that emits light into a medium with a refractive index of less than or equal to approximately 1.25; and
   - a collimating optical element disposed to receive the light emitted from the light emitting surface of the chip, the collimating optical element having an entrance surface, wherein the medium is disposed between the entrance surface and the light emitting surface of the chip.

2. The apparatus of Claim 0, wherein the collimating optical element and the chip are separated by a distance that is less than or equal to approximately 50% of the width of the chip.

3. The apparatus of Claim 0, wherein the collimating optical element is a lens.

4. The apparatus of Claim 0, further comprising a holding element that holds the collimating optical element.

5. The apparatus of Claim 0, wherein the holding element has a ring shape and includes a notch and the lens has a tab that is held in the notch.

6. The apparatus of Claim 0, wherein the light emitting diode further comprises a submount, the chip being mounted on the submount, and wherein the holding element is mounted on the submount by reflow soldering.

7. The apparatus of Claim 0, further comprising a secondary collimating optical element disposed over the collimating optical element such that the collimating optical element is disposed between the second collimating optical element and the chip.

8. The apparatus of Claim 0, further comprising:

   - an array of light emitting diodes, each light emitting diode comprising a chip having a light emitting surface that emits light into a medium having a refractive index of less than or equal to approximately 1.25; and
   - at least one collimating optical element being disposed to receive the light emitted from the light emitting surfaces of each chip, the at least one collimating optical element having an entrance surface, wherein the medium is disposed between the entrance surface of the at least one collimating optical element and the light emitting surface of each chip.

9. The apparatus of Claim 0, wherein the at least one collimating optical element comprises an array of collimating optical elements, each collimating optical element being disposed to receive the light emitted from the light emitting surface of an associated chip, each collimating optical element having an entrance surface, wherein the medium is disposed between the entrance surface and the light emitting surface of the associated chip.

10. The apparatus of Claim 0, wherein the array of collimating optical elements is an integral array of lenses.

**11.** The apparatus of Claim 0, wherein at least one chip is displaced laterally with respect to the center of the associated collimating optical element.

**12.** The apparatus of Claim 0, wherein the light emitting diode further comprises a submount and an array of chips mounted on the submount, each chip in the array of chips having a light emitting surface that emits light into a medium having a refractive index of less than or equal to approximately 1.25, and wherein the collimating optical element is disposed to receive the light emitted from the light emitting surface of each chip in the array of chips.

**13.** The apparatus of Claim 0, further comprising a micro-display disposed to receive light emitted from the light emitting surface of the chip after passing through the collimating optical element.

**14.** The apparatus of Claim 0, wherein the chip includes one of a wavelength converting layer, a diffractive layer, a micro-refractive layer, and a filter layer and a polarizer layer that forms the light emitting surface.

**15.** The apparatus of Claim 0, wherein the medium is the ambient environment.

**16.** The apparatus of Claim 0, wherein the ambient environment is one of air and gas.

**17.** An apparatus comprising:

- a light emitting diode comprising a chip having a light emitting surface, wherein the light emitting surface is not covered by an encapsulant such that the light emitting surface emits light directly into the ambient environment; and
- a collimating optical element disposed to receive the light emitted from the light emitting surface of the chip through the ambient environment.

**18.** The apparatus of Claim 0, wherein the collimating optical element is at least one lens.

**19.** The apparatus of Claim 0, further comprising a micro-display disposed to receive the light emitted from the light emitting surface of the chip after the light passes through the collimating optical element.

**20.** The apparatus of Claim 0, further comprising a secondary collimating optical element disposed between the micro-display and the collimating optical element.

**21.** The apparatus of Claim 0, wherein the light emitting diode further comprises a submount, the apparatus further comprising:

- a holding element that holds the collimating optical element, the holding element being mounted on the submount.

**22.** The apparatus of Claim 0, wherein the holding element has a ring shape and includes a notch and the lens has a tab that is held in the notch.

**23.** The apparatus of Claim 0, further comprising:

- an array of light emitting diodes, each light emitting diode comprising a chip having a light emitting surface, wherein the light emitting surface is not covered by an encapsulant such that the light emitting surface emits light directly into the ambient environment; and
- at least one collimating optical element being disposed to receive the light emitted from the light emitting surfaces of each chip.

**24.** The apparatus of Claim 0, wherein the at least one collimating optical element comprises an array of collimating optical elements.

**25.** The apparatus of Claim 0, wherein the array of collimating optical elements is an integral array of lenses.

**26.** The apparatus of Claim 0, wherein at least one chip is displaced laterally with respect to the center of the associated collimating optical element.

**27.** The apparatus of Claim 0, wherein the light emitting diode further comprises a submount and an array of chips mounted on the submount, each chip in the array of chips having a light emitting surface and wherein the light emitting surface of each chip in the array of chips is not covered by an encapsulant, and wherein the collimating optical element is disposed to receive the light emitted from the light emitting surface of each chip in the array of chips through the ambient environment.

**28.** The apparatus of Claim 0, wherein the chip includes a wavelength converting layer that forms the light emitting surface.

**29.** The apparatus of Claim 0, wherein the ambient environment is one of air and gas.

**30.** The apparatus of Claim 0, wherein the chip includes one of a wavelength converting layer, a diffractive layer, a micro-refractive layer, and a filter layer and a polarizer layer that forms the light emitting surface.

**31.** An apparatus comprising:

- a light emitting diode comprising a chip having a light emitting surface that emits light into a medium with a refractive index of less than or equal to approximately 1.25;
- a collimating optical element disposed to receive the light emitted from the light emitting surface of the chip; and
- a micro-display disposed to receive the light emitted from the light emitting surface of the chip after the light passes through the collimating optical element.

**32.** The apparatus of Claim 0, wherein the collimating optical element is at least one lens.

**33.** The apparatus of Claim 0, further comprising a secondary collimating optical element disposed between the micro-display and the collimating optical element.

**34.** The apparatus of Claim 0, wherein the light emitting diode further comprises a submount, and the apparatus further comprising:

- a holding element that holds the collimating optical element, the holding element being mounted on the submount.

**35.** The apparatus of Claim 0, wherein the holding element is annular and includes a notch and wherein the collimating optical element has a tab that is held in the notch.

**36.** A method comprising:

- providing a light emitting diode chip with a light emitting surface that emits light directly into a medium having a refractive index of less than or equal to approximately 1.25;
- providing an optical element; and
- mounting the optical element with respect to the light emitting diode so that light emitted from the light emitting surface passes through the medium prior to being received by the optical element.

**37.** The method of Claim 0, wherein the medium having a refractive index of less than or equal to approximately 1.25 is one of air and gas.

**38.** The method of Claim 0, further comprising:

- focusing the light emitted from the light emitting surface with the optical element after the light passes through the medium; and
- causing the focused light to be incident on a target.

**39.** The method of Claim 0, wherein mounting the optical element comprises mounting the optical element to a submount on which the light emitting diode chip is mounted.

**40.** The method of Claim 0, wherein the optical element is a primary optical element, the method further comprising providing a secondary optical element and mounting the secondary optical element to receive light from the primary optical element.

**41.** The method of Claim 0, wherein mounting the optical element comprises laterally displacing the center of the optical element with respect to the light emitting surface chip.

**42.** The method of Claim 0, further comprising:

- providing a plurality of light emitting diode chips each having a light emitting surface that emits light directly into a medium having a refractive index of less than or equal to approximately 1.25; and
- wherein mounting the optical element comprises mounting the optical element with respect to the plurality of light emitting diode chips so that light emitted from the light emitting surface of each of the light emitting diode chips passes through the medium prior to being received by the optical element.

Fig. 1A

Fig. 1B

Fig. 1C

52

54

56

## Fig. 2A

60

64

52

62

64

## Fig. 2B

Relative
Luminous
Flux (%)

70

74

72

Etendue (mm²sr)

## Fig. 3

Fig. 4

Fig. 5A

Fig. 5B

Fig. 6

Fig. 7

Fig. 8

Fig. 9

300

302 200 200

200 254

## Fig. 10

350

356

252

354 202

254

400 352

## Fig. 11

302

402 202

402 202

404

402 202

## Fig. 12

450 ⟋

252

456

204

254

454

208

452R  452G  452B

# Fig. 13

# EP 1 566 847 A1

**European Patent Office**

## EUROPEAN SEARCH REPORT

Application Number

EP 05 10 0676

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2002/079837 A1 (OKAZAKI JUN) 27 June 2002 (2002-06-27) | 1,17,36 | H01L33/00 |
| Y | * paragraph [0115] - paragraph [0121]; figure 11 * | 7,31 | |
| X | EP 0 592 746 A (INTERNATIONAL BUSINESS MACHINES CORPORATION) 20 April 1994 (1994-04-20) * column 4, line 1 - line 21; figures 2,3c,4c * | 1,2 | |
| X | EP 0 269 337 A (AMERICAN TELEPHONE AND TELEGRAPH COMPANY) 1 June 1988 (1988-06-01) * figures 3,4 * | 1,5 | |
| Y | PATENT ABSTRACTS OF JAPAN vol. 2003, no. 12, 5 December 2003 (2003-12-05) & JP 2003 330109 A (SEIKO EPSON CORP), 19 November 2003 (2003-11-19) * abstract; figures 1-8 * | 31 | TECHNICAL FIELDS SEARCHED (Int.Cl.7) H01L G02B |
| Y | PATENT ABSTRACTS OF JAPAN vol. 2003, no. 11, 5 November 2003 (2003-11-05) & JP 2003 218017 A (RICOH CO LTD), 31 July 2003 (2003-07-31) * abstract; figures 1-3 * | 7 | |

The present search report has been drawn up for all claims

| Place of search | Date of completion of the search | Examiner |
|---|---|---|
| Munich | 9 May 2005 | Thieme, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

15

**ANNEX TO THE EUROPEAN SEARCH REPORT
ON EUROPEAN PATENT APPLICATION NO.**

EP 05 10 0676

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2005

| Patent document<br>cited in search report | | Publication<br>date | Patent family<br>member(s) | | Publication<br>date |
|---|---|---|---|---|---|
| US 2002079837 | A1 | 27-06-2002 | JP<br>JP<br>US | 3614776 B2<br>2002185046 A<br>2004036081 A1 | 26-01-2005<br>28-06-2002<br>26-02-2004 |
| EP 0592746 | A | 20-04-1994 | EP<br>AT<br>DE<br>DE<br>ES<br>JP<br>JP<br>US | 0592746 A1<br>150593 T<br>69218431 D1<br>69218431 T2<br>2101074 T3<br>2501004 B2<br>6204622 A<br>5414293 A | 20-04-1994<br>15-04-1997<br>24-04-1997<br>25-09-1997<br>01-07-1997<br>29-05-1996<br>22-07-1994<br>09-05-1995 |
| EP 0269337 | A | 01-06-1988 | US<br>EP<br>JP | 4772123 A<br>0269337 A2<br>63144314 A | 20-09-1988<br>01-06-1988<br>16-06-1988 |
| JP 2003330109 | A | 19-11-2003 | NONE | | |
| JP 2003218017 | A | 31-07-2003 | NONE | | |

For more details about this annex : see Official Journal of the European Patent Office, No. 12/82